# EUROPEAN PATENT SPECIFICATION

(11) **EP 1 329 023 B1**
(45) Date of publication and mention of the grant of the patent: **09.05.2007**
(21) Application number: 00957252.0
(22) Date of filing: 25.07.2000
(51) Int. Cl.: H03K 3/12

(54) **THREE-TERMINAL INVERTING HYSTERETIC TRANSISTOR SWITCH BACKGROUND OF THE INVENTION**
INVERTIERENDER HYSTERETISCHER TRANSISTORSCHALTER MIT DREI ANSCHLÜSSEN HINTERGRUND DER ERFINDUNG
COMMUTATEUR A TRANSISTOR A TROIS BORNES ET A INVERSION D'HYSTERESE

(43) Date of publication of application: 23.07.2003
(73) Proprietor: CONGDON, James S., Sudbury, MA 01776 (US)
(72) Inventor: CONGDON, James S., Sudbury, MA 01776 (US)
(74) Representative: Schubert, Klemens
(86) International application number: PCT/US2000/020203
(87) International publication number: WO 2002/009282

(56) References cited:
- US-A- 5 952 870

## Description

### BACKGROUND OF THE INVENTION

The present invention relates generally to transistor switches and, more particularly, to inverting transistor switches.

Transistor switches, or transistors, are well known in the art and are commonly used. Transistors are solid-state electronic devices which are capable of amplification and switching.

Inverting transistors are well known in the art and are commonly used to invert an input signal. Inverting transistors, such as bipolar transistors and metal-oxide semiconductor field effect transistors (MOSFETs), typically contain only three terminals. Specifically, inverting transistors contain an input terminal, an output terminal which is used to connect the transistor to a load and a ground terminal. Contrary to the configuration of noninverting transistors, inverting transistors do not require a fourth terminal connected to a power supply, thereby rendering inverting transistors more desirable than noninverting transistors.

In U.S. Patent No. 5,134,323 to J.S. Congdon, there is disclosed a noninverting transistor switch having only three terminals. In one embodiment, the three terminal noninverting transistor switch includes first, second and third terminals, a depletion mode field effect transistor (FET) having drain and source electrodes that define a current path in the transistor and are connected to the third and second terminals respectively and a gate electrode for controlling the current flow in the transistor current path. A negative voltage converter having an input electrode, an output electrode and a return electrode has its output electrode coupled to the gate electrode in the FET, its return electrode coupled to the source electrode and its input electrode coupled to the first terminal. In operation, the current flow between the drain and source electrodes will be high when a low signal is applied to the input electrode with respect to the source electrode and will be lower when a higher signal is applied to the input electrode with respect to the source electrode. In another embodiment, the noninverting switch having only three terminals includes first, second and third transistors, wherein the third transistor is coupled through circuitry to the first terminal of the noninverting transistor switch to provide a controlled amount of positive feedback which results in hysteresis or "Schmitt-trigger" like variation of the first terminal input threshold voltage.

Three terminal inverting transistors typically experience a notable drawback. Specifically, a noisy input signal which approaches the threshold voltage for a three terminal inverting transistor can often cause the transistor to experience unwanted state changes or even to remain in between an on switching state and an off switching state, this in-between condition being prone to oscillation and high power dissipation.

Accordingly, switching devices which experience hysteresis are desirable. Hysteretic switches reduce the problem of a noisy input signal causing the switching device to experience unwanted state conditions by using two different threshold voltages. Switching devices which experience hysteresis typically use a high threshold voltage, commonly referred to as the rising or positive threshold voltage, to switch the device during low-to-high input signal transitions and a lower threshold voltage, commonly referred to as the falling or negative threshold voltage, to switch the device during high-to-low input signal transitions.

Schmitt triggers are one well-known type of hysteretic switching device. A Schmitt trigger is a form of a bistable multivibrator and is often used in applications where square waves with a constant amplitude are needed or where sine waves require conversion to square waves. Due to its hysteretic properties, Schmitt triggers are effectively immune to a noisy input signal as long as the peak-to-peak amplitude of the input noise signal is less than the difference between the rising and falling threshold voltages for the device.

In use, a Schmitt trigger functions in the following manner. The Schmitt trigger output voltage remains low until the input signal voltage crosses the rising threshold voltage for the device. Once the input signal voltage crosses the rising threshold voltage for the device, the Schmitt trigger is actuated and the output voltage abruptly rises. Once the input signal voltage falls below the falling threshold voltage for the device, the Schmitt trigger produces an output voltage which drops to a low voltage state almost instantly.

Schmitt triggers are undesirable because the device requires four terminals as opposed to inverting transistors which require only three terminals. In addition to an input terminal, an output terminal and a ground terminal, Schmitt triggers require a power supply terminal, which is undesirable.

Silicon controlled rectifiers (SCR) are four-layer unidirectional devices for bistable switching. A silicon controlled rectifier is essentially a rectifier diode which additionally comprises a control element.

It should be noted that silicon controlled rectifiers are inverting, experience hysteresis and comprise only three terminals, which is desirable.

However, silicon controlled rectifiers experience a notable drawback. Specifically, silicon controlled rectifiers experience output signal actuated hysteresis, which is less desirable than switching devices which experience input signal actuated hysteresis, such as Schmitt triggers. In particular, silicon controlled rectifiers experience output current actuated hysteresis which is load dependent, and therefore highly undesirable.

In use, a silicon controlled rectifier functions in the following manner. The silicon controlled rectifier remains off until the input signal voltage crosses the rising threshold for the device. Once the input signal voltage crosses the rising threshold voltage for the device, the silicon controlled rectifier is actuated and the output current abruptly rises. However, when the input signal voltage falls even below ground, the silicon controlled rectifier does not experience a drop to zero in output current. Unlike the Schmitt trigger, the silicon controlled rectifier can not be said to have a falling input threshold voltage. To the contrary, during turn-off, silicon controlled rectifiers are output signal dependent because the output current must be brought nearly to zero for the silicon controlled rectifier to turn off.

Electromechanical relay circuits are electromechanical coil and contact devices which control power distributed to a load by energizing an isolated input circuit. Electromechanical relay circuits can be built using electrically isolated input and output circuits. In use, an input signal energizes an electromagnet that attracts a hinged and spring-loaded element commonly referred to as an armature. Output contacts, attached to but insulated from the armature, are opened or closed by the movement of the armature. In the closed position, the contacts apply power to the load. In the open position, the contacts remove power to the load.

It should be noted that electromechanical relay circuits can be connected to be inverting, experience input signal actuated hysteresis and comprise only three terminals, which is highly desirable.

However, inverting electromechanical relay circuits experience a number of alternative drawbacks. Specifically, electromechanical relay circuits require a large amount of input power, are large, are slow and are unreliable, which is highly undesirable.

United States Patent no. 5 952 870 discloses an inverting hysteretic transistor switch having only three terminals, said three terminals being an input terminal, an output terminal and a ground terminal, said inverting hysteretic transistor switch comprising:
a) a first field effect transistor (FET) having a drain terminal, a source terminal and a gate terminal, the source terminal of said first FET being connected to the ground terminal;
b) a second field effect transistor (FET) having a drain terminal, a source terminal and a gate terminal, the gate terminal of said second FET being connected to the drain terminal of said first FET;
c) a third field effect transistor (FET) having a drain terminal, a source terminal and a gate terminal, the source terminal of said third FET being connected to the ground terminal, the drain terminal of said third FET being connected to the output terminal and the gate terminal of said third FET being connected to the gate terminal of said first FET; and
d) a resistor having a first terminal and a second terminal, the first terminal of said resistor being connected to the input terminal and the second terminal of said resistor being connected to the drain terminal of said first FET.

### SUMMARY OF THE INVENTION

It is an object of the present invention to provide a new and improved transistor switch.

It is another object of the present invention to provide a transistor switch that is inverting.

It is yet another object of the present invention to provide a transistor switch as described above which contains only three terminals.

It is still another object of the present invention to provide a transistor switch as described above which experiences hysteresis.

It is a further object of the present invention to provide a transistor switch as described above which experiences input signal actuated hysteresis.

It is yet another object of the present invention to provide an electric switch as described above which can be mass produced, has a minimal number of parts, is limited in size, operates quickly, is reliable, requires a limited amount of input power and can be very easily used.

Accordingly, there is provided an inverting hysteretic transistor switch as defined in claim 1 and in claim 6.

Additional objects, as well as features and advantages, of the present invention will be set forth in part in the description which follows, and in part will be obvious from the description or may be learned by practice of the invention. In the description, reference is made to the accompanying drawings which form a part thereof and in which is shown by way of illustration particular embodiments for practicing the invention. The embodiments will be described in sufficient detail to enable those skilled in the art to practice the invention, and it is to be understood that other embodiments may be utilized and that structural changes may be made without departing from the scope of the invention. The following detailed description is, therefore, not to be taken in a limiting sense, and the scope of the present invention is defined by the appended claims.

### BRIEF DESCRIPTION OF THE DRAWINGS

The accompanying drawings, which are hereby incorporated into and constitute a part of this specification, illustrate particular embodiments of the invention and, together with the description, serve to explain the principles of the invention. In the drawings wherein like reference numerals represent like parts:
Fig. 1 is a schematic representation of a first embodiment of a three-terminal inverting hysteretic transistor switch constructed according to the teachings of the present invention, the switch being shown with an external load;
Fig. 2 is a graphical representation comparing an input voltage signal with an output voltage signal for the three-terminal inverting hysteretic transistor switch shown in Fig. 1;
Fig. 3 is a chart useful in understanding the operation of the three-terminal inverting hysteretic transistor switch shown in Fig. 1;
Fig. 4 is a schematic representation of a second embodiment of a three-terminal inverting hysteretic transistor switch constructed according to the teachings of the present invention, the switch being shown with an external load;
Fig. 5 is a chart useful in understanding the operation of the three-terminal inverting hysteretic transistor switch shown in Fig. 4; and
Fig. 6 is a schematic representation of a third embodiment of a three-terminal inverting hysteretic transistor switch constructed according to the teachings of the present invention, the switch being shown with an external load;

### DETAILED DESCRIPTION OF A PREFERRED EMBODIMENT

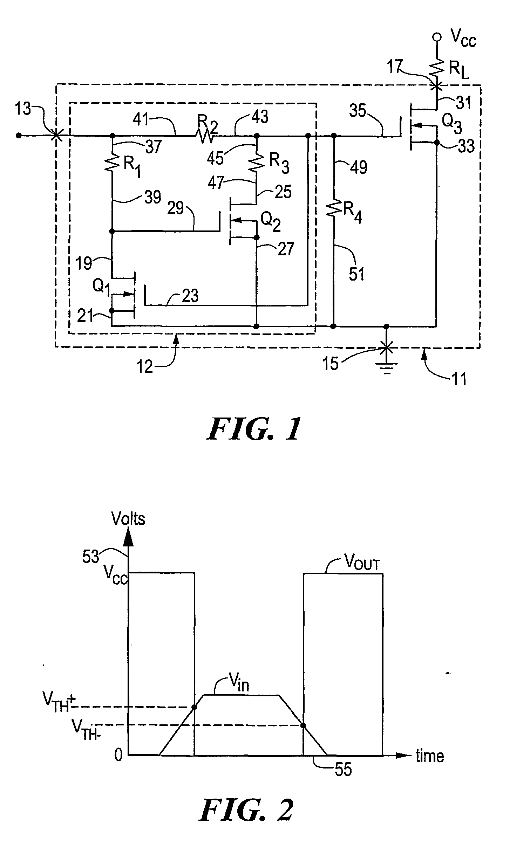

Referring now to Fig. 1, there is shown a first embodiment of a three-terminal inverting hysteretic transistor switch constructed according to the teachings of the present invention, the switch being represented generally by reference numeral 11. As will be described further in detail below, switch 11 is inverting, experiences input signal actuated hysteresis and comprises only three terminals.

Switch 11 comprises an input terminal 13, a ground terminal 15 and an output terminal 17. As can be appreciated, input terminal 13, ground terminal 15 and output terminal 17 are the only terminals for switch 11, which is an object of the present invention.

Switch 11 also comprises a first MOSFET Q₁, a second MOSFET Q₂ and a third MOSFET Q₃. First MOSFET Q₁, second MOSFET Q₂ and third MOSFET Q₃ are identical. Specifically, first MOSFET Q₁, second MOSFET Q₂ and third MOSFET Q₃ are all preferably N-channel, enhancement-mode, VN2222LL-model MOSFETs, each preferably having a MOSFET threshold voltage V_{FETTH} of approximately 1.2 volts. However, it is to be understood that first MOSFET Q₁, second MOSFET Q₂ and third MOSFET Q₃ are not limited to having a threshold voltage of approximately 1.2 volts. In addition, it is to be understood that first MOSFET Q₁, second MOSFET Q₂ and third MOSFET Q₃ are not limited to having equal threshold voltages. Rather, it is to be understood that first MOSFET Q₁, second MOSFET Q₂ and third MOSFET Q₃ could each have different threshold voltage values from one another.

First MOSFET Q₁ includes a drain electrode 19, a source electrode 21 connected to ground and a gate electrode 23. Second MOSFET Q₂ includes a drain electrode 25, a source electrode 27 connected to ground and a gate electrode 29 connected to drain electrode 19 of first MOSFET Q₁. Third MOSFET Q₃ includes a drain electrode 31 connected to output terminal 17, a source electrode 33 connected to ground terminal 15 and a gate electrode 35 connected to gate electrode 23 of first MOSFET Q₁.

Switch 11 further comprises a first resistor R₁, a second resistor R₂ and a third resistor R₃. First resistor R₁ preferably has a value of approximately 120 Kohms and includes a first terminal 37 connected to input terminal 13 and a second terminal 39 connected to drain electrode 19 of first MOSFET Q₁. Second resistor R₂ preferably has a value of approximately 120 Kohms and includes a first terminal 41 connected to input terminal 13 and a second terminal 43 connected to gate electrode 23 of first MOSFET Q₁. Third resistor R₃ preferably has a value of approximately 120 Kohms and includes a first terminal 45 connected to gate electrode 23 of first MOSFET Q₁ and a second terminal 47 connected to drain electrode 25 of second MOSFET Q₂.

Switch 11 additionally comprises a fourth resistor R₄. Fourth resistor R₄ preferably has a value of approximately 1.0 Mohms and includes a first terminal 49 connected to gate electrode 23 of first MOSFET Q₁ and a second terminal 51 connected to ground. It should be noted that fourth resistor R₄ is required because first MOSFET Q₁, second MOSFET Q₂ and third MOSFET Q₃ are identical. However, if first MOSFET Q₁, second MOSFET Q₂ and third MOSFET Q₃ had unequal threshold voltage values which would result in second MOSFET Q₂ turning on at a lower input voltage than first MOSFET Q₁ and third MOSFET Q₃ during use, fourth resistor R₄ could be eliminated from switch 11.

Output terminal 17 can be connected through a load resistor R_{L} to a supply voltage V_{cc}, load resistor R_{L} preferably having a value of 1.0 Kohms. As can be appreciated, both load resistor R_{L} and supply voltage V_{cc} are external to switch 11 and consequently are not to be considered part of the present invention.

It should be noted that an additional device, such as a diode, PNP bipolar transistor, P-channel FET, or programmable unijunction transistor (PUT), could optionally be connected to input terminal 13 and gate electrode 35 in parallel with second resistor R₂. As can be appreciated, the device would serve to assist in removing charge from gate electrode 35of third MOSFET Q₃.

Together, first MOSFET Q₁, second MOSFET Q₂, first resistor R₁, second resistor R₂ and third resistor R₃ form a hysteresis circuit 12 for third MOSFET Q₃. Specifically, third MOSFET Q₃ acts as the output switch for switch 11. Hysteresis circuit 12 provides a high threshold voltage to gate electrode 35, commonly referred to as the rising or positive threshold voltage, to switch third MOSFET Q₃ on during low-to-high input signal transitions and a lower threshold voltage to gate electrode 35, commonly referred to as the falling or negative threshold voltage, to switch third MOSFET Q₃ off during high-to-low input signal transitions, as will be described in detail below.

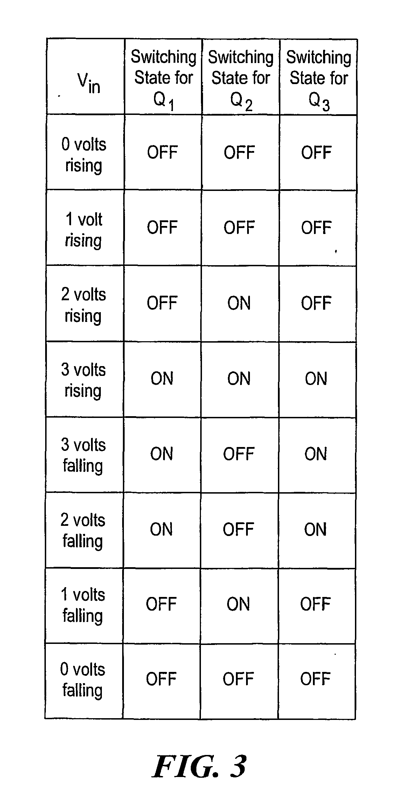

In use, switch 11 functions in the following manner. Fig. 2 represents a graphical representation comparing an input voltage signal Vᵢₙ with an output voltage signal Vₒᵤₜ for switch 11, the graphical representation having a vertical axis 53 representing voltage and a horizontal axis 55 representing time. Fig. 3 represents a chart showing the switching state of first, second and third MOSFETs Q₁, Q₂ and Q₃ at selected points for input voltage signal Vᵢₙ. Referring to Figs. 1-3, with input voltage Vᵢₙ representing a trapezoidal wave and with the time at zero, input voltage Vᵢₙ is at zero. With input voltage Vᵢₙ at zero, first MOSFET Q₁, second MOSFET Q₂ and third MOSFET Q₃ are all off. With third MOSFET Q₃ off, no current passes through load resistor R_{L}. As a result, output voltage Vₒᵤₜ at output terminal 17 will be approximately V_{cc}, discarding any leakage.

As input voltage Vᵢₙ is slowly increased, once input voltage Vᵢₙ equals 1.0 x MOSFET threshold voltage V_{FETTH} (approximately 1.2 volts), second MOSFET Q₂ will turn on because, with virtually no current in first resistor R₁, the voltage at gate electrode 29 of second MOSFET Q₂ is approximately the value of input voltage Vᵢₙ. Once input voltage Vᵢₙ equals MOSFET threshold voltage V_{FETTH}, second MOSFET Q₂ will have the value of MOSFET threshold voltage V_{FETTH} at gate electrode 29 and, as a consequence, second MOSFET Q₂ will turn on, with first MOSFET Q₁ and third MOSFET Q₃ remaining off. Once second MOSFET Q₂ turns on, current will flow through second resistor R₂ and third resistor R₃. Second resistor R₂ and third resistor R₃ together act as voltage dividers. As a result, voltage at the junction of second resistor R₂ and third resistor R₃ will then pass into gate electrodes 23 and 35 of first and third MOSFETs Q₁ and Q₃, respectively, with gate electrode 35 of third MOSFET Q₃ receiving approximately ½ of input voltage Vᵢₙ and gate electrode 23 of first MOSFET Q₁ also receiving approximately ½ of input voltage Vᵢₙ.

As input voltage Vᵢₙ increases, eventually first and third MOSFETs Q₁ and Q₃ will turn on once input voltage Vᵢₙ equals approximately 2.1 x MOSFET threshold voltage V_{FETTH} (approximately 2.5 volts), this value of Vᵢₙ being identified as the rising threshold voltage V_{TH+} for switch 11 in Fig. 2. When first MOSFET Q₁ turns on, first MOSFET Q₁ pulls down the voltage at gate electrode 29 of second MOSFET Q₂ until second MOSFET Q₂ turns off. With second MOSFET Q₂ off, no current flows through third resistor R₃. As a consequence, the voltage at gate electrode 35 of third MOSFET Q₃ will rise from approximately 1.0 x MOSFET threshold voltage V_{FETTH} to approximately 1.9 x MOSFET threshold voltage V_{FETTH}. As a result, switch 11 abruptly turns on, thereby causing rising threshold hysteresis for switch 11 which causes output voltage Vₒᵤₜ to drop to approximately zero volts, as shown in Fig. 2.

As input voltage Vᵢₙ begins to drop at the tail end of the trapezoidal waveform, third MOSFET Q₃ will turn off once input voltage Vᵢₙ equals approximately 1.1 x MOSFET threshold voltage V_{FETTH} (approximately 1.3 volts), this value of Vᵢₙ being identified as the falling threshold voltage V_{TH-} for switch 11 in Fig. 2. Specifically, due to the specific values of second resistor R₂ and fourth resistor R₄, once input voltage Vᵢₙ equals approximately 1.1 x MOSFET threshold voltage V_{FETTH}, gate 35 at third MOSFET Q₃ has a voltage of approximately MOSFET threshold voltage V_{FETTH}. Similarly, once input voltage Vᵢₙ drops below approximately 1.1 x MOSFET threshold voltage V_{FETTH}, first MOSFET Q₁ will turn off. Once first MOSFET Q₁ turns off, second MOSFET Q₂ will turn back on. With second MOSFET Q₂ back on, the voltage at gate electrode 35 of third MOSFET Q₃ will lower, thereby making first and third MOSFETs Q₁ and Q₃ turn off. Once first and third MOSFETs Q₁ and Q₃ turn off, output voltage Vₒᵤₜ at output terminal 17 will abruptly return to approximately V_{cc}, as shown in Fig. 2, discarding any leakage.

It should be noted that rising threshold voltage V_{TH+} (approximately 2.5 volts) is significantly higher than the falling threshold voltage V_{TH-} (approximately 1.3 volts), as shown in Fig. 2. As a result, a noisy input voltage signal Vᵢₙ will not cause switch 11 to experience unwanted state changes, which is desirable.

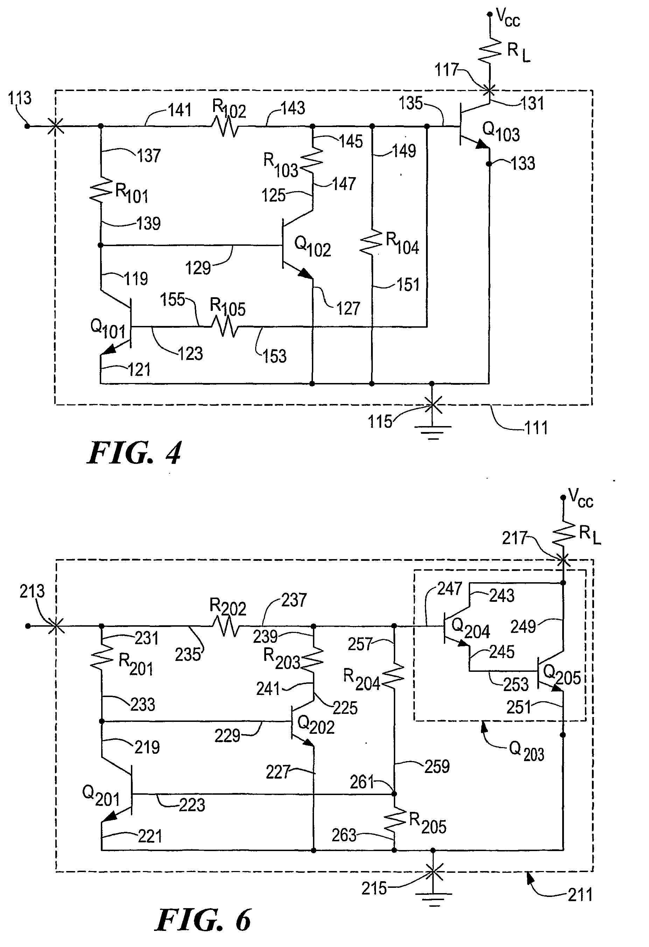

Referring now to Fig.4, there is shown a second embodiment of a three-terminal inverting hysteretic transistor switch constructed according to the teachings of the present invention, the switch being identified as reference numeral 111. Switch 111 is similar to switch 11 in that switch 111 is also inverting, experiences input signal actuated hysteresis and comprises only three terminals.

The principle distinction between switch 111 and switch 11 is that switch 111 comprises a first bipolar junction transistor (BJT) Q₁₀₁, a second bipolar junction transistor (BJT) Q₁₀₂ and a third bipolar junction transistor (BJT) Q₁₀₃ in place of first MOSFET Q₁, second MOSFET Q₂ and third MOSFET Q₃, respectively, of switch 11. In use, switch 11 and switch 111 function in a similar manner.

It should be noted that although switch 11 is shown comprising three MOSFETs and switch 111 is shown comprising three bipolar junction transistors, additional switch embodiments which comprise combinations of MOSFETs and bipolar junction transistors could readily be manufactured.

Switch 111 comprises an input terminal 113, a ground terminal 115 and an output terminal 117. As can be appreciated, input terminal 113, ground terminal 115 and output terminal 117 are the only terminals for switch 111, which is an object of the present invention.

First bipolar junction transistor (BJT) Q₁₀₁, second bipolar junction transistor (BJT) Q₁₀₂ and third bipolar junction transistor (BJT) Q₁₀₃ are identical. Specifically, first bipolar junction transistor (BJT) Q₁₀₁, second bipolar junction transistor (BJT) Q₁₀₂ and third bipolar junction transistor (BJT) Q₁₀₃ are all preferably NPN 2N2222-type bipolar junction transistors, each preferably having a BJT threshold voltage V_{BJTTH} of approximately 0.7 volts. However, it is to be understood that first BJT Q₁₀₁, second BJT Q₁₀₂ and third BJT Q₁₀₃ are not limited to having a threshold voltage of approximately 0.7 volts. In addition, it is to be understood that first BJT Q₁₀₁, second BJT Q₁₀₂ and third BJT Q₁₀₃ are not limited to having equal threshold voltages. Rather, it is to be understood that first BJT Q₁₀₁, second BJT Q₁₀₂ and third BJT Q₁₀₃ could each have different threshold voltage values from one another without departing from the spirit of the present invention.

First BJT Q₁₀₁ includes a collector electrode 119, an emitter electrode 121 connected to ground and a base electrode 123. Second BJT Q₁₀₂ includes a collector electrode 125, an emitter electrode 127 connected to ground and a base electrode 129 connected collector electrode 119 of first BJT Q₁₀₁. Third BJT Q₁₀₃ includes a collector electrode 131 connected to output terminal 117, an emitter electrode 133 connected to ground terminal 115 and a base electrode 135.

Switch 111 further comprises a first resistor R₁₀₁, a second resistor R₁₀₂ and a third resistor R₁₀₃. First resistor R₁₀₁ preferably has a value of approximately 1.0 Mohms and includes a first terminal 137 connected to input terminal 113 and a second terminal 139 connected to collector electrode 119 of first BJT Q₁₀₁. Second resistor R₁₀₂ preferably has a value of approximately 22 Kohms and includes a first terminal 141 connected to input terminal 113 and a second terminal 143 connected to base electrode 135 of third BJT Q₁₀₃. Third resistor R₁₀₃ preferably has a value of approximately 120 Kohms and includes a first terminal 145 connected to base electrode 135 of third BJT Q₁₀₃ and a second terminal 147 connected to collector electrode 125 of second BJT Q₁₀₂.

Switch 111 additionally comprises a fourth resistor R₁₀₄. Fourth resistor R₁₀₄ preferably has a value of approximately 120 Kohms and includes a first terminal 149 connected to base electrode 135 of third BJT Q₁₀₃ and a second terminal 151 connected to ground. It should be noted that fourth resistor R₁₀₄ is required because first BJT Q₁₀₁, second BJT Q₁₀₂ and third BJT Q₁₀₃ are identical. However, if first BJT Q₁₀₁, second BJT Q₁₀₂ and third BJT Q₁₀₃ had unequal turn-on threshold voltage values which would result in second BJT Q₁₀₂ turning on before first BJT Q₁₀₁ and third BJT Q₁₀₃ during use, fourth resistor R₁₀₄ could be eliminated from switch 111.

Output terminal 117 can be connected through a load resistor R_{L} to a supply voltage V_{CC}, load resistor R_{L} preferably having a value of 1.0Kohms. As can be appreciated, both load resistor R_{L} and supply voltage V_{CC} are external to switch 111 and consequently are not to be considered part of the present invention.

Switch 111 further comprises a fifth resistor R₁₀₅. Fifth resistor R₁₀₅ preferably has a value of approximately 1.0 Mohms and includes a first terminal 153 connected to base electrode 135 of third BJT Q₁₀₃ and a second terminal 155 connected to base electrode 123 of first BJT Q₁₀₁. However, it should be noted that if the current flowing into base electrode 123 of first BJT Q₁₀₁ does not reduce the amount of current available to drive base electrode 135 of third BJT Q₁₀₃ to less current than is needed for third BJT Q₁₀₃ to switch the load current through load resistor R_{L} and thus ensure proper operation of switch 111, fifth resistor R₁₀₅ could alternatively have a value of zero ohms. If fifth resistor R₁₀₅ has a value of zero ohms, first terminal 153 and second terminal 155 are connected together.

It should be noted that an additional device, such as a diode, PNP bipolar transistor, P-channel FET, or programmable unijunction transistor (PUT), could optionally be connected to input terminal 113 and base electrode 135 in parallel with second resistor R₁₀₂. As can be appreciated, the device would serve to assist in removing charge from base electrode 135 of third BJT Q₁₀₃.

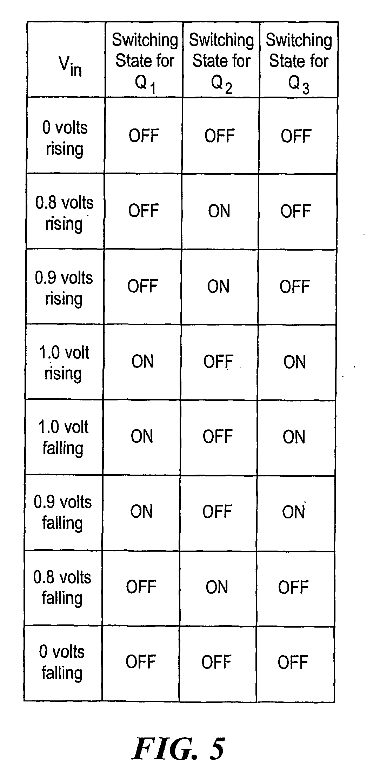

In use, switch 111 functions in a similar manner to switch 11. In particular, switch 111 similarly has a rising threshold voltage which is significantly higher than its falling threshold voltage, as shown in Fig. 5. As a result, a noisy input signal will not cause switch 111 to experience unwanted state changes, which is desirable.

Referring now to Fig.6, there is shown a third embodiment of a three-terminal inverting hysteretic transistor switch constructed according to the teachings of the present invention, the switch being identified as reference numeral 211. Switch 211 is similar to switch 111 in that switch 211 is also inverting, experiences input signal actuated hysteresis and comprises only three terminals.

Switch 211 is similar to switch 111 in that switch 211 comprises an input terminal 213, a ground terminal 215 and an output terminal 217. As can be appreciated, input terminal 213, ground terminal 215 and output terminal 217 are the only terminals for switch 211, which is an object of the present invention.

Switch 211 is similar to switch 111 in that switch 211 comprises a first bipolar junction transistor (BJT) Q₂₀₁ and a second bipolar junction transistor (BJT) Q₂₀₂ which are identical in construction with first BJT Q₁₀₁ and second BJT Q₁₀₂ of switch 111. Preferably, first BJT Q₂₀₁ and second BJT Q₂₀₂ are both NPN 2N2222-type bipolar junction transistors, each preferably having a BJT threshold voltage V_{BJTTH} of approximately 0.7 volts. However, it is to be understood that first BJT Q₂₀₁ and second BJT Q₂₀₂ are not limited to having a threshold voltage of approximately 0.7 volts. In addition, it is to be understood that first BJT Q₂₀₁ and second BJT Q₂₀₂ are not limited to having equal threshold voltages. Rather, it is to be understood that first BJT Q₂₀₁ and second BJT Q₂₀₂ could each have different threshold voltage values from one another.

First BJT Q₂₀₁ includes a collector electrode 219, an emitter electrode 221 connected to ground and a base electrode 223. Second BJT Q₂₀₂ includes a collector electrode 225, an emitter electrode 227 connected to ground and a base electrode 229 connected to collector electrode 219 of first BJT Q₂₀₁.

Switch 211 also comprises a first resistor R₂₀₁, a second resistor R₂₀₂ and a third resistor R₂₀₃. First resistor R₂₀₁ preferably has a value of approximately 1.0 Mohms and includes a first terminal 231 connected to input terminal 213 and a second terminal 233 connected to collector electrode 219 of first BJT Q₂₀₁. Second resistor R₂₀₂ preferably has a value of approximately 120 Kohms and includes a first terminal 235 connected to input terminal 213 and a second terminal 237. Third resistor R₂₀₃ preferably has a value of approximately 1.0 Mohms and includes a first terminal 239 connected to second terminal 237 of second resistor R₂₀₂ and a second terminal 241 connected to collector terminal 225 of second BJT Q₂₀₂.

The principle distinction between switch 211 and switch 111 is that switch 211 comprises a Darlington-connected compound bipolar junction transistor Q₂₀₃ in place of third BJT Q₁₀₃ of switch 111. Darlington-connected compound BJT Q₂₀₃ is desirable in that it has twice the turn-on threshold voltage of either first BJT Q₂₀₁ or second BJT Q₂₀₂. As a consequence, no resistor is required in switch 211 to perform the function performed by fourth resistor R₁₀₄ in switch 111. Darlington-connected compound BJT Q₂₀₃ is also desirable because it can switch relatively high current and voltage with small die area.

Darlington-connected compound BJT Q₂₀₃ comprises a fourth BJT Q₂₀₄ and a fifth BJT Q₂₀₅. Preferably, fourth BJT Q₂₀₄ and fifth BJT Q₂₀₅ are both NPN TIP121-type bipolar junction transistors, each preferably having a BJT threshold voltage V_{BJTTH} of approximately 1.4 volts or approximately two times the voltage of the threshold voltage of first BJT Q₂₀₁ and second BJT Q₂₀₂.

Fourth BJT Q₂₀₄ includes a collector electrode 243 connected to output terminal 217, an emitter electrode 245 and a base electrode 247 connected to second terminal 237 of second resistor R₂₀₂. Fifth BJT Q₂₀₅ includes a collector electrode 249 connected to output terminal 217, an emitter electrode 251 connected to ground and a base electrode 253 connected to emitter electrode 245 of fourth BJT Q₂₀₄.

Switch 111 additionally comprises a fourth resistor R₂₀₄ and a fifth resistor R₂₀₅ which together act as a resistor divider for increasing the effective turn-on voltage threshold of first BJT Q₂₀₁. Fourth resistor R₂₀₄ preferably has a value of approximately 1.0 Mohms and includes a first terminal 257 connected to base electrode 247 of fourth BJT Q₂₀₄ and a second terminal 259 connected to base electrode 223 of first BJT Q₂₀₁. Fifth resistor R₂₀₅ preferably has a value of approximately 1.0 Mohms and includes a first terminal 261 connected to second terminal 259 of fourth resistor R₂₀₄ and a second terminal 263 connected to ground.

Output terminal 217 can be connected through a load resistor R_{L} to a supply voltage V_{CC}, load resistor R_{L} preferably having a value of 1.0Kohms. As can be appreciated, both load resistor R_{L} and supply voltage V_{CC} are external to switch 211 and consequently are not to be considered part of the present invention.

It should be noted that an additional device, such as a diode, PNP bipolar transistor, P-channel FET, or programmable unijunction transistor (PUT), could optionally be connected to input terminal 213 and base electrode 247 in parallel with second resistor R₂₀₂ without departing from the spirit of the present invention. As can be appreciated, the device would serve to assist in removing charge from base electrode 247 of fourth BJT Q₂₀₄.

In use, switch 211 functions in a similar manner to switch 111. In particular, switch 211 similarly has a rising threshold voltage which is significantly higher than its falling threshold voltage. As a result, a noisy input signal will not cause switch 211 to experience unwanted state changes, which is desirable.

## Claims

1. An inverting hysteretic transistor (11) switch having only three terminals, said three terminals being an input terminal (13), an output terminal (17) and a ground terminal (15), said inverting hysteretic transistor switch comprising:
a. a first field effect transistor (FET) (Q₁) having a drain terminal, a source terminal and a gate terminal, the source terminal of said first FET being connected to the ground terminal;
b. a second field effect transistor (FET) (Q₂) having a drain terminal, a source terminal and a gate terminal, the source terminal of said second FET being connected to the ground terminal and the gate terminal of said second FET being connected to the drain terminal of said first FET;
c. a third field effect transistor (FET) (Q₃) having a drain terminal, a source terminal and a gate terminal, the source terminal of said third FET being connected to the ground terminal, the drain terminal of said third FET being connected to the output terminal and the gate terminal (35) of said third FET being connected to the gate terminal (23) of said first FET;
d. a first resistor (R₁) having a first terminal and a second terminal, the first terminal of said first resistor being connected to the input terminal and the second terminal of said first resistor being connected to the drain terminal (19) of said first FET;
e. a second resistor (R₂) having a first terminal and a second terminal, the first terminal of said second resistor being connected to the input terminal and the second terminal of said second resistor being connected to the gate terminal (23) of said first FET; and
f. a third resistor (R₃) having a first terminal and a second terminal, the first terminal of said third resistor is connected to the gate terminal (23) of said first FET and the second terminal of said third resistor is connected to the drain terminal (25) of said second FET.

2. The inverting hysteretic transistor switch of claim 1 wherein each of said first, second and third field effect transistors are N-channel, enhancement-mode, metal-oxide semiconductor field effect transistors (MOSFETs).

3. The inverting hysteretic transistor switch of claim 2 wherein said first, second and third field effect transistors (FETs) have equal threshold voltages.

4. The inverting hysteretic transistor switch of claim 3 wherein said first, second and third resistors are approximately 120 Kohms.

5. The inverting hysteretic transistor switch of claim 4 further comprising a fourth resistor (R₄) having a first terminal and a second terminal, the first terminal of said fourth resistor being connected to the gate terminal (35) of said third FET and the second terminal of said fourth resistor being connected to ground.

6. An inverting hysteretic transistor switch (111,211) having only three terminals, said three terminals being an input terminal (113,213), an output terminal (117,217) and a ground terminal (115,215), said inverting hysteretic transistor switch comprising:
a. a first transistor (Q₁₀₁, Q₂₀₁) having a collector electrode (119,219), a base electrode (123,223) and an emitter electrode (121,221) connected to the ground terminal;
b. a second transistor (Q₁₀₂, Q₂₀₂) having a collector electrode (125, 225), a base electrode (129, 229) connected to the collector electrode of said first transistor and an emitter electrode (127,227) connected to the ground terminal;
c. a third transistor (Q₁₀₃, Q₂₀₃) having a collector electrode (131, 243, 249) connected to the output terminal, a base electrode (135, 247) connected to the base electrode of said first transistor and an emitter electrode (133, 251) connected to the ground terminal;
d. a first resistor (R₁₀₁, R₂₀₁) having a first terminal (137,231) connected to the input terminal and a second terminal connected to the collector electrode of said first transistor;
e. a second resistor (R₁₀₂, R₂₀₂) having a first terminal (141, 235) connected to the input terminal and a second terminal (143, 237) connected to the base electrode of said third transistor; and
f. a third resistor (R₁₀₃, R₂₀₃) having a first terminal (145,239) connected to the base electrode of said third transistor and a second terminal (125,241) connected to the collector electrode of said second transistor.

7. The inverting hysteretic transistor switch of claim 6 wherein said third transistor is a Darlington-connected compound bipolar junction transistor.

8. The inverting hysteretic transistor switch of claim 7 wherein the base electrode (135,247) of said third transistor is connected to the base electrode (123,223) of said first transistor through a fourth resistor (R₁₀₅,R₂₀₄) having a first terminal (153,257) connected to the base electrode of said third transistor and a second terminal (155,261) connected to the base electrode of said first transistor.

9. The inverting hysteretic transistor switch of claim 8 further comprising a fifth resistor (R₂₀₅) having a first terminal (261) connected to the second terminal of said fourth resistor and a second terminal (263) connected to the ground terminal.

10. The inverting hysteretic transistor switch of claim 6 wherein each of said first, second and third transistors are NPN bipolar junction transistors (BJTs).

## Patentansprüche

1. Invertierender hysteretischer Transistorschalter (11) mit nur drei Anschlüssen, wobei die drei Anschlüsse ein Eingangsanschluß (13), ein Ausgangsanschluß (17) und ein Masseanschluß (15) sind, wobei der invertierende hysteretische Transistorschalter folgendes umfaßt:
a. einen ersten Feldeffekttransistor bzw. FET (Q₁) mit einem Drainanschluß, einem Sourceanschluß und einem Gateanschluß, wobei der Sourceanschluß des ersten FET mit dem Masseanschluß verbunden ist;
b. einen zweiten Feldeffekttransistor bzw. FET (Q₂) mit einem Drainanschluß, einem Sourceanschluß und einem Gateanschluß, wobei der Sourceanschluß des zweiten FET mit dem Masseanschluß und der Gateanschluß des zweiten FET mit dem Drainanschluß des ersten FET verbunden ist;
c. einen dritten Feldeffekttransistor bzw. FET (Q₃) mit einem Drainanschluß, einem Sourceanschluß und einem Gateanschluß, wobei der Sourceanschluß des dritten FET mit dem Masseanschluß verbunden ist, der Drainanschluß des dritten FET mit dem Ausgangsanschluß verbunden ist und der Gateanschluß (35) des dritten FET mit dem Gateanschluß (22) des ersten FET verbunden ist;
d. einen ersten Widerstand (R₁) mit einem ersten Anschluß und einem zweiten Anschluß, wobei der erste Anschluß des ersten Widerstands mit dem Eingangsanschluß und der zweite Anschluß des ersten Widerstands mit dem Drainanschluß (19) des ersten FET verbunden ist;
e. einen zweiten Widerstand (R₂) mit einem ersten Anschluß und einem zweiten Anschluß, wobei der erste Anschluß des zweiten Widerstands mit dem Eingangsanschluß und der zweite Anschluß des zweiten Widerstands mit dem Gateanschluß (23) des ersten FET verbunden ist; und
f. einen dritten Widerstand (R₃) mit einem ersten Anschluß und einem zweiten Anschluß, wobei der erste Anschluß des dritten Widerstands mit dem Gateanschluß (23) des ersten FET verbunden ist und der zweite Anschluß des dritten Widerstands mit dem Drainanschluß (25) des zweiten FET verbunden ist.

2. Invertierender hysteretischer Transistorschalter nach Anspruch 1, wobei jeder des ersten, des zweiten und des dritten Feldeffekttransistors N-Kanal-Metalloxid-Halbleiterfeldeffekttransistoren des Anreichungsmodus (MOSFET) sind.

3. Invertierender hysteretischer Transistorschalter nach Anspruch 2, wobei der erste, der zweite und der dritte Feldeffekttransistor (FET) gleiche Schwellenspannungen aufweisen.

4. Invertierender hysteretischer Transistorschalter nach Anspruch 3, wobei der erste, der zweite und der dritte Widerstand ungefähr 120 kOhm betragen.

5. Invertierender hysteretischer Transistorschalter nach Anspruch 4, ferner mit einem vierten Widerstand (R₄) mit einem ersten Anschluß und einem zweiten Anschluß, wobei der erste Anschluß des vierten Widerstands mit dem Gateanschluß (35) des dritten FET und der zweite Anschluß des vierten Widerstands mit Masse verbunden ist.

6. Invertierender hysteretischer Transistorschalter (111, 211) mit nur drei Anschlüssen, wobei die drei Anschlüsse ein Eingangsanschluß (113, 213), ein Ausgangsanschluß (117, 217) und ein Masseanschluß (115, 215) sind, wobei der invertierende hysteretische Transistorschalter folgendes umfaßt:
a. einen ersten Transistor (Q₁₀₁, Q₂₀₁) mit einer Kollektorelektrode (119, 219), einer Basiselektrode (123, 223) und einer Emitterelektrode (121, 221), die mit dem Masseanschluß verbunden ist;
b. einen zweiten Transistor (Q₁₀₂, Q₂₀₂) mit einer Kollektorelektrode (125, 225), einer mit der Kollektorelektrode des ersten Transistors verbundenen Basiselektrode (129, 229) und einer mit dem Masseanschluß verbundenen Emitterelektrode (127, 227);
c. einen dritten Transistor (Q₁₀₃, Q₂₀₃) mit einer mit dem Ausgangsanschluß verbundenen Kollektorelektrode (131, 243, 249), einer mit der Basiselektrode des ersten Transistors verbundenen Basiselektrode (135, 247) und einer mit dem Masseanschluß verbundenen Emitterelektrode (133, 251);
d. einen ersten Widerstand (R₁₀₁, R₂₀₁), mit einem mit dem Eingangsanschluß verbundenen ersten Anschluß (137, 231) und einem mit der Kollektorelektrode des ersten Transistors verbundenen zweiten Anschluß;
e. einen zweiten Widerstand (R₁₀₂, R₂₀₂) mit einem mit dem Eingangsanschluß verbundenen ersten Anschluß (141, 235) und einem mit der Basiselektrode des dritten Transistors verbundenen zweiten Anschluß (143, 237); und
f. einen dritten Widerstand (R₁₀₃, R₂₀₃) mit einem mit der Basiselektrode des dritten Transistors verbundenen ersten Anschluß (145, 239) und einem mit der Kollektorelektrode des zweiten Transistors verbundenen zweiten Anschluß (125, 241).

7. Invertierender hysteretischer Transistorschalter nach Anspruch 6, wobei der dritte Transistor ein Verbund-Bipolar-Sperrschichttransistor in Darlington-Schaltung ist.

8. Invertierender hysteretischer Transistorschalter nach Anspruch 7, wobei die Basiselektrode (135,247) des dritten Transistors durch einen vierten Widerstand (R₁₀₅, R₂₀₄) mit einem mit der Basiselektrode des dritten Transistors verbundenen ersten Anschluß (153, 257) und einem mit der Basiselektrode des ersten Transistors verbundenen zweiten Anschluß (155, 261) mit der Basiselektrode (123, 223) des ersten Transistors verbunden ist.

9. Invertierender hysteretischer Transistorschalter nach Anspruch 8, ferner mit einem fünften Widerstand (R₂₀₅) mit einem mit dem zweiten Anschluß des vierten Widerstands verbundenen ersten Anschluß (261) und einem mit dem Masseanschluß verbundenen zweiten Anschluß (263).

10. Invertierender hysteretischer Transistorschalter nach Anspruch 6, wobei jeder des ersten, des zweiten und des dritten Transistors ein NPN-Bipolar-Sperrschichttransistor (BJT) ist.

## Revendications

1. Commutateur inverseur (11) à transistors à hystérésis doté de trois bornes seulement, lesdites trois bornes étant une borne d'entrée (13), une borne de sortie (17) et une borne de terre (15), ledit commutateur inverseur à transistors à hystérésis comportant :
a. un premier transistor à effet de champ (FET) (Q₁) doté d'une borne de drain, d'une borne de source et d'une borne de grille, la borne de source dudit premier FET étant reliée à la borne de terre ;
b. un deuxième transistor à effet de champ (FET) (Q₂) doté d'une borne de drain, d'une borne de source et d'une borne de grille, la borne de source dudit deuxième FET étant reliée à la borne de terre et la borne de grille dudit deuxième FET étant reliée à la borne de drain dudit premier FET ;
c. un troisième transistor à effet de champ (FET) (Q₃) doté d'une borne de drain, d'une borne de source et d'une borne de grille, la borne de source dudit troisième FET étant reliée à la borne de terre, la borne de drain dudit troisième FET étant reliée à la borne de sortie et la borne de grille (35) dudit troisième FET étant reliée à la borne de grille (23) dudit premier FET ;
d. une première résistance (R₁) dotée d'une première borne et d'une deuxième borne, la première borne de ladite première résistance étant reliée à la borne d'entrée et la deuxième borne de ladite première résistance étant reliée à la borne de drain (19) dudit premier FET ;
e. une deuxième résistance (R₂) dotée d'une première borne et d'une deuxième borne, la première borne de ladite deuxième résistance étant reliée à la borne d'entrée et la deuxième borne de ladite deuxième résistance étant reliée à la borne de grille (23) dudit premier FET ;
f. une troisième résistance (R₃) dotée d'une première borne et d'une deuxième borne, la première borne de ladite troisième résistance étant reliée à la borne de grille (23) dudit premier FET et la deuxième borne de ladite troisième résistance étant reliée à la borne de drain (25) dudit deuxième FET.

2. Commutateur inverseur à transistors à hystérésis selon la revendication 1, chacun desdits premier, deuxième et troisième transistors à effet de champ étant un transistor métal-oxyde semiconducteur à effet de champ (MOSFET) canal N à enrichissement.

3. Commutateur inverseur à transistors à hystérésis selon la revendication 2, lesdits premier, deuxième et troisième transistors à effet de champ (FET) présentant des tensions seuil égales.

4. Commutateur inverseur à transistors à hystérésis selon la revendication 3, lesdites première, deuxième et troisième résistances valant approximativement 120 kOhms.

5. Commutateur inverseur à transistors à hystérésis selon la revendication 4, comportant en outre une quatrième résistance (R₄) dotée d'une première borne et d'une deuxième borne, la première borne de ladite quatrième résistance étant reliée à la borne de grille (35) dudit troisième FET et la deuxième borne de ladite quatrième résistance étant reliée à la terre.

6. Commutateur inverseur (111, 211) à transistors à hystérésis doté de trois bornes seulement, lesdites trois bornes étant une borne d'entrée (113, 213), une borne de sortie (117, 217) et une borne de terre (115, 215), ledit commutateur inverseur à transistors à hystérésis comportant :
a. un premier transistor (Q₁₀₁, Q₂₀₁) doté d'une électrode de collecteur (119, 219), d'une électrode de base (123, 223) et d'une électrode d'émetteur (121, 221) reliée à la borne de terre ;
b. un deuxième transistor (Q₁₀₂, Q₂₀₂) doté d'une électrode de collecteur (125, 225), d'une électrode de base (129, 229) reliée à l'électrode de collecteur dudit premier transistor et d'une électrode d'émetteur (127, 227) reliée à la borne de terre ;
c. un troisième transistor (Q₁₀₃, Q₂₀₃) doté d'une électrode de collecteur (131, 243, 249) reliée à la borne de sortie, d'une électrode de base (135, 247) reliée à l'électrode de base dudit premier transistor et d'une électrode d'émetteur (133, 251) reliée à la borne de terre ;
d. une première résistance (R₁₀₁, R₂₀₁) dotée d'une première borne (137, 231) reliée à la borne d'entrée et d'une deuxième borne reliée à l'électrode de collecteur dudit premier transistor ;
e. une deuxième résistance (R₁₀₂, R₂₀₂) dotée d'une première borne (141, 235) reliée à la borne d'entrée et d'une deuxième borne (143, 237) reliée à l'électrode de base dudit troisième transistor ; et
f. une troisième résistance (R₁₀₃, R₂₀₃) dotée d'une première borne (145, 239) reliée à l'électrode de base dudit troisième transistor et d'une deuxième borne (125, 241) reliée à l'électrode de collecteur dudit deuxième transistor.

7. Commutateur inverseur à transistors à hystérésis selon la revendication 6, ledit troisième transistor étant un transistor bipolaire à jonctions branché en Darlington.

8. Commutateur inverseur à transistors à hystérésis selon la revendication 7, l'électrode de base (135,247) dudit troisième transistor étant reliée à l'électrode de base (123,223) dudit premier transistor à travers une quatrième résistance (R₁₀₅, R₂₀₄) dotée d'une première borne (153, 257) reliée à l'électrode de base dudit troisième transistor et d'une deuxième borne (155, 261) reliée à l'électrode de base dudit premier transistor.

9. Commutateur inverseur à transistors à hystérésis selon la revendication 8, comportant en outre une cinquième résistance (R₂₀₅) dotée d'une première borne (261) reliée à la deuxième borne de ladite quatrième résistance et d'une deuxième borne (263) reliée à la borne de terre.

10. Commutateur inverseur à transistors à hystérésis selon la revendication 6, chacun des premier, deuxième et troisième transistors étant un transistor bipolaire à jonctions (BJT) NPN.
